# EUROPEAN PATENT APPLICATION

(11) **EP 1 124 328 A1**
(43) Date of publication of application: **16.08.2001**
(21) Application number: 00307404.4
(22) Date of filing: 29.08.2000
(51) Int. Cl.: H03H 9/02, H03H 3/08

(54) **A method of fabricating a zinc oxide based resonator**

(30) Priority: 10.02.2000 US 501403
(71) Applicant: LUCENT TECHNOLOGIES INC., Murray Hill, New Jersey 07974-0636 (US)
(72) Inventor: Kowach, Glen Robert, Fanwood, New Jersey 07023 (US)
(74) Representative: Williams, David John

(57) **Abstract**

A method of fabricating a resonator (40) is disclosed. The method initially comprises the step of providing a substrate base (50,65) having a dielectric layer(s) (70-105). Thereafter, an adhesive layer (115) is formed on the dielectric layer(s), and a nucleation promoting film (120) is formed over the adhesive layer. A zinc oxide layer (125) is subsequently formed over the nucleation promoting film, and a top conductive layer (130) is formed over the layer of zinc oxide.

## Description

### FIELD OF THE INVENTION

The present invention relates to resonators, generally, and more particularly to a method of fabricating a zinc oxide based resonator.

### BACKGROUND OF THE INVENTION

With the increasing commercialization of electronic devices operating at frequencies of greater than 500 MHz, such as, for example, personal communication service ("PCS") systems, cellular telephones, cordless telephones, pagers, and communication satellites, the limitations associated with conventional resonators have become increasingly apparent. Traditional resonators employ a piezoelectric crystal for vibrating at resonant frequencies, including a fundamental and harmonics, in response to the application of an alternating electric field. The fundamental frequency created by this phenomenon is defined by the acoustic velocity (v) of the energy transmitted through the film divided by twice the thickness of the film. Relying on this relationship, as is well known, acoustic reflecting layers may also be added to reflect desired frequencies, while suppressing unwanted others, such as particular harmonics.

The proliferation of wireless networks has increased research efforts into alternative materials suitable for resonator applications of 400 MHz and greater. This drive is buttressed by the practical limitations in manufacturing sufficiently thin crystals from traditional materials, such as quartz or ceramics. Given the relationship between resonating frequency and thickness, the demand for higher and higher frequency resonators has in turn led to the examination of alternative thin film materials having sufficient strength.

Resonators formed from thin film materials typically comprise a piezoelectric material, at least one pair of electrodes for applying an electric field(s) to the piezoelectric dielectric, and at least one pair of reflecting surfaces for establishing a standing wave. In certain thin film based resonator applications, the electrodes are realized by thin film metal layers which may also serve as the reflecting surfaces. For the purposes of the present disclosure, thin film based resonators shall refer to both bulk acoustic wave ("BAW") devices and surface acoustic wave ("SAW") devices.

In a typical resonator, a metal/air interface formed by the electrode at the top of the resonator acts as the primary source of reflection. Sandwiched between the top and bottom electrodes is a piezoelectric layer comprising a textured thin film. For the purposes of the present disclosure, a textured thin film is defined as oriented and atomically ordered, crystalline structure, as viewed by X-ray diffraction, which falls in between a range of random polycrystalline at one boundary, and monocrystalline at the other boundary. Further, an X-ray diffraction rocking curve may be used to quantity the degree of texture. If the resonator is a BAW device, the textured piezoelectric layer has a polar direction normal to the surface of the resonator substrate. If the resonator is a SAW device, the textured piezoelectric layer may have the polar direction either normal or parallel to the surface of the resonator substrate. As the bottom metallic layer is typically formed over a substrate, the resonator may also comprise an air gap acoustic cavity defined within the substrate base.

Various materials have been examined in the quest for resonator formed from thin films capable of precisely handing frequencies above 400 MHz. The analysis has primarily focused on two variables, a quality factor, *Q*, and an electro-mechanical coupling coefficient, *k*². The quality factor, *Q*, addresses the resonance quality of the resonator, while the coupling coefficient, *k*², speaks to the efficiency of conversion between electrical and mechanical energy of the resonator. Both *Q* and *k*² are inversely proportional to an intrinsic acoustic loss introduced by the resonator within its defined operating frequency band. *See generally* Campbell, Surface Acoustic Wave Devices and Their Signal Processing Applications, Academic Press, Inc., 1989 (hereinafter "Campbell") hereby incorporated by reference, and Rosenbaum, Bulk Acoustic Wave Theory and Device, Artech House, 1988 (hereinafter "Rosenbaum").

Of the presently available textured thin films, aluminum nitride and zinc oxide have shown promise. While having certain advantages regarding its potential integration with semiconductor devices on a single die, aluminum nitride has been observed and is known to those skilled in the art as having a smaller coupling coefficient (*k*²) than zinc oxide. As the coupling coefficient (*k*²) corresponds with the bandwidth of the resultant resonator, zinc oxide has a distinctive advantage in resonator applications of greater than 400 MHz.

A thin film of zinc oxide has two characteristics from which its suitability for resonator applications may be analyzed. First, zinc oxide may be formed in an amorphous or crystalline structural state. The order, or lack thereof, of the zinc oxide atoms within the thin film corresponds to its structural state. As such, when zinc oxide is formed as a thin film at a temperature below which nucleation does not occur, and/or doped, it may comprise an amorphous state. For the purposes of the present disclosure, nucleation is defined as the promotion of crystallization of a textured film, irrespective of the structure of the substrate on which it is formed. Likewise, zinc oxide exhibits a textured crystalline structure when formed with a known heating cycle. As a thin film in a resonator, it is an objective to form the zinc oxide with the highest possible crystallinity, the highest possible orientation, thus yielding the highest value for electromechanical coupling coefficient, *k*², as well as the lowest possible loss for its utilization as a controllable vibrating element.

Zinc oxide, moreover, is intrinsically resistive. This characteristic is functionally related to the number of defects - vacancies, interstitials and/or stacking faults - or the purity of the zinc oxide. Thus, if the zinc oxide employed is relatively impure or the number of defects high, the resistivity should be relatively low. Likewise, if the zinc oxide selected is relatively pure and the number of defects low, the resistivity will be relatively high. For resonator type applications, it is advantageous to use zinc oxide with the highest possible resistivity, and therefore utilize a relatively high purity zinc oxide.

While thin film zinc oxides have been employed in resonators, recognized methods exist for fabricating zinc oxide thin films which have produced structures with limited piezoelectricity, and thereby capped crystallinity, orientation and resistivity. These known methods have been shown, using X-ray diffraction, to have limited rocking curves, intensity, as well as other measurable characteristics including additional diffraction peaks.

As a result, a demands exists for a thin film based zinc oxide resonator and a method of making the same having greater crystallinity and orientation without impacting its resistivity.

### SUMMARY OF THE INVENTION

A method of fabricating a resonator is disclosed. According to a first embodiment, the method initially comprises the step of providing a resonator substrate base. An adhesive layer is formed over the resonator substrate base, and thereafter a nucleation promoting film is formed over the adhesive layer. A zinc oxide crystalline layer is subsequently formed over the nucleation promoting film, and a second conductive layer is formed over the crystalline layer of zinc oxide. The limitations associated with the known methods for fabricating zinc oxide thin films are overcome by employing the nucleation promoting film which promotes nucleation of the zinc oxide layer. In a further embodiment of the present invention, the nucleation promoting film promotes the texturing the zinc oxide layer. As such, the zinc oxide layer is textured, and has increased crystallinity and orientation, independent of the type substrate on which the resonator is formed.

According to another embodiment of the present invention, a method of fabricating a resonator is disclosed. The method initially comprises the step of providing a resonator substrate base having an adhesive layer. Thereafter, a nucleation promoting film of Pt is formed over the adhesive layer. A crystalline layer of zinc oxide is subsequently reactively sputtered over the nucleation promoting film. The nucleation promoting film promotes increased crystallinity and orientation in the formation of the zinc oxide layer, independent of the type substrate on which the resonator is formed. In a further embodiment of the present invention, the nucleation promoting film promotes the texturing the zinc oxide layer. A top electrode is then formed over the zinc oxide layer.

According to another embodiment of the present invention, a resonator is disclosed. The resonator comprises a resonator substrate base and an adhesive layer. A nucleation promoting film is formed over the adhesive layer, and a crystalline layer of zinc oxide is formed over the conductive, nucleation promoting film. The nucleation promoting film promotes increased crystallinity and orientation during the formation of the zinc oxide layer, independent of the type substrate on which the resonator is formed. In a further embodiment, the nucleation promoting film promotes the texturing the zinc oxide layer. The resonator further comprises a top electrode over the thin film layer of zinc oxide.

According to another embodiment of the present invention, an electronic device is disclosed employing a resonator. The electronic device comprises an antenna for receiving or transmitting at least one signal, as well as a filter for. filtering the at least one signal. Moreover, the electronic device comprise an amplifier for amplifying the at least one signal and a mixer for mixing the at least one signal. The mixer comprises an oscillator having a resonator. The resonator comprises a resonator substrate base, an adhesive layer formed over the resonator substrate base, a nucleation promoting film over the adhesive layer, a crystalline layer of zinc oxide formed over the nucleation promoting film, and a top electrode formed over the zinc oxide layer. The nucleation promoting film is non-oxidizing, and has, for example, a <111> orientation with a face centered cubic ("fcc") structure. Further, the nucleation promoting film promotes increased crystallinity and orientation during the formation of the zinc oxide layer. In a further embodiment, the nucleation promoting film promotes the texturing the zinc oxide layer.

These and other advantages and objects will become apparent to those skilled in the art from the following detailed description read in conjunction with the appended claims and the drawings attached hereto.

### BRIEF DESCRIPTION OF THE DRAWINGS

The present invention will be better understood from reading the following description of non-limiting embodiments, with reference to the attached drawings, wherein below:
**FIG. 1** is a perspective of an embodiment of the present invention;
**FIG. 2** is a cross-sectional view of an embodiment of the present invention;
**FIGS. 3(a)** and **3(b)** are cross-sectional views of further embodiments of the present invention;
**FIGS. 4(a)** and **4(b)** are top views of a first and second aspect of the present invention;
**FIG. 5** is a flow chart according to another embodiment of the present invention;
**FIG. 6** is a graph illustrating resistivity (Ω-cm), diffraction rocking angle (degrees) and temperature (°C) characteristics of an embodiment of the present invention; and
**FIG. 7** is a block diagram of another embodiment of the present invention.

It should be emphasized that the drawings of the instant application are not to scale but are merely schematic representations, and thus are not intended to portray the specific parameters or the structural details of the invention, which can ' be determined by one of skill in the art by examination of the information herein.

### DETAILED DESCRIPTION OF THE PRESENT INVENTION

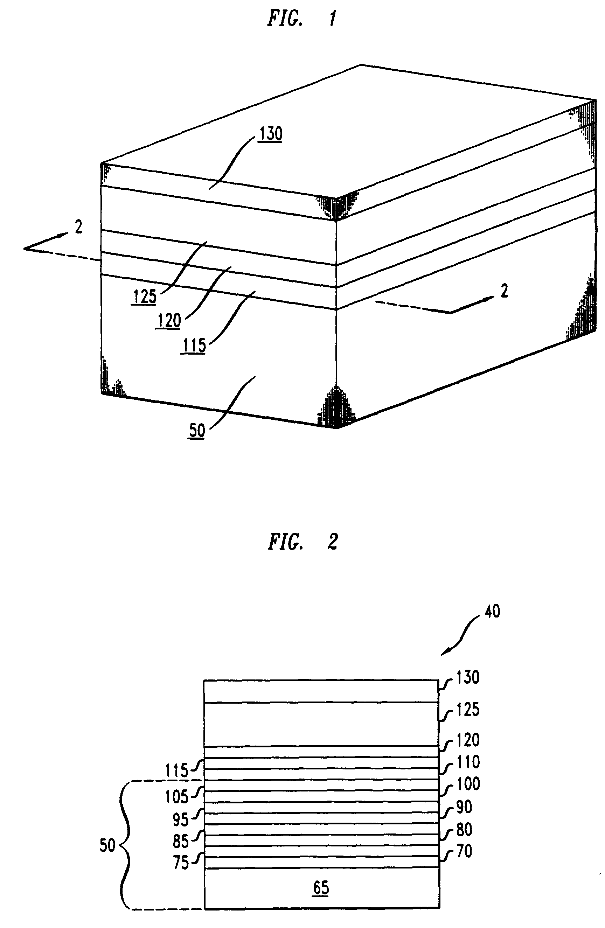

Referring to **FIGS. 1** and **2,** a resonator **40** according to an embodiment of the present invention is illustrated. Resonator **40** may be a Bulk Acoustic Wave ("BAW") device. However, a Surface Acoustic Wave ("SAW") device may also be formed with the inclusion of InterDigital Transducers ("IDT"), as will be understood from disclosure hereinbelow.

Resonator **40** comprises a resonator substrate base **50.** It should be apparent to one of ordinary skill in the art that resonator substrate base **50** may also comprise an air gap acoustic cavity (not shown). Substrate base **50** comprises a substrate layer **65.** Substrate layer **65** comprises silicon (Si). In the alternative, however, substrate layer **65** may also comprise diamond, quartz, silicon carbide (SiC), sapphire (Al₂O₃), gallium arsenide (GaAs), as well as other materials apparent to one of ordinary skill in the art upon reviewing the present disclosure.

Resonator substrate base **50** also comprises a stack of dielectric layers formed on substrate layer **65.** With respect to BAW devices, the stack of dielectric layers functionally provides acoustic reflectivity, as well as electrically insulating substrate layer **65** from subsequently formed conductive layers detailed hereinbelow. It should be noted for SAW resonator applications, substrate layer **65** should have a higher acoustic velocity relative to BAW resonator applications. However, it should also be recognized that for SAW applications, the stack of dielectric layers are not incorporated over the resonator substrate layer **65.** Likewise, for BAW resonator applications, substrate layer **65** and the dielectric layers formed thereon should have a higher acoustic impedance in comparison with SAW resonator applications.

The dielectric stack, in one example, comprises at least one set of alternating amorphous silicon dioxide (a-SiO₂) and amorphous aluminum nitride (a-AIN) layers. The dielectric stack here may be realized by a nine (9) layer stack comprising amorphous silicon dioxide (a-SiO₂) layers, **70, 80, 90,** and **100,** and amorphous aluminum nitride (a-AIN) layers **75, 85, 95** and **105** formed respectively thereon, and an uppermost amorphous silicon dioxide (a-SiO₂) layer **110** disposed above amorphous aluminum nitride (a-AlN) layer **105.** It should be apparent to one of ordinary skill in the art that alternative arrangements and materials may also be employed in the above exemplary dielectric stack. Therefore, for example, silicon dioxide may be used in place of amorphous silicon dioxide (a-SiO₂), and likewise, aluminum nitride (AlN) may be substituted for amorphous aluminum nitride (a-AlN).

Resonator **40** further comprises an adhesive layer **115** formed on amorphous silicon dioxide (a-SiO₂) layer **110.** Adhesive layer **115** functionally provides adhesive properties for a subsequent layer formed thereon, as detailed hereinbelow. Adhesive layer **115** is continuous, though the formation of pinholes should not preclude its use. Adhesive layer **115** comprises titanium (Ti) or chromium (Cr), though substitutes, such as, for example, zirconium (Zr), halfnium (Hf), vanadium (V), niobium (Nb), tantalum (Ta), molybdenum (Mo), and tungsten (W), as well as certain alloys will become apparent to one of ordinary skill upon reviewing the disclosure herein. Adhesive layer **115** may be formed by a sputtering step, as will understood from disclosure below.

A bottom electrode **120** is formed above adhesive layer **115.** Electrode **120** comprises a nucleation promoting film for promoting nucleation and crystallinity in a subsequently formed textured crystalline layer, as will be evident from the disclosure hereinbelow. It should be noted that in a further embodiment of the present invention, electrode **120** is also patterned.

Bottom electrode **120** comprises platinum (Pt). Various non-oxidizing conducting alternatives for promoting subsequent crystal growth, such as gold (Au), rhodium (Rh), palladium (Pd), silver (Ag) and iridium (Ir), for example, however, may also employed as substitutes. It is also advantageous for bottom electrode **120** to be non-oxidizing, have an orientation of <111> face centered cubic ("fcc") structure, normal to the surface of resonator substrate **50.**

Additionally, resonator **40** comprises a textured piezoelectric layer **125** having an oriented and atomically ordered, crystalline structure with a polar axis - *c*- axis for Wurtzite structured materials - normal to the surface of resonator substrate **50.** Textured piezoelectric layer **125** comprises zinc oxide. Substitutes and alternative ranges, however, such as, for example, aluminum nitride (AlN), as well as other materials having the Wurtzite structure, will become apparent to one of ordinary skill in the art upon reviewing the disclosure herein. Zinc oxide layer **125** may be formed by a reactive sputtering step, as will understood from disclosure below.

Formed above textured piezoelectric layer **125** is a top electrode **130.** In another embodiment of the present invention, top electrode **120** is also patterned. The pattern associated with top electrode **130** corresponds to whether resonator **40** is a BAW or SAW device. *See* Campbell *and* Rosenbaum. Electrode **130** comprises titanium (Ti) or platinum (Pt), though various alternatives having conductive and non-oxidizing properties, such as Au and palladium (P), for example, may also be employed. In still another embodiment, electrode **130** comprises an orientation of <111> face centered cubic ("fcc") structure, normal to the surface of the resonator substrate **50.**

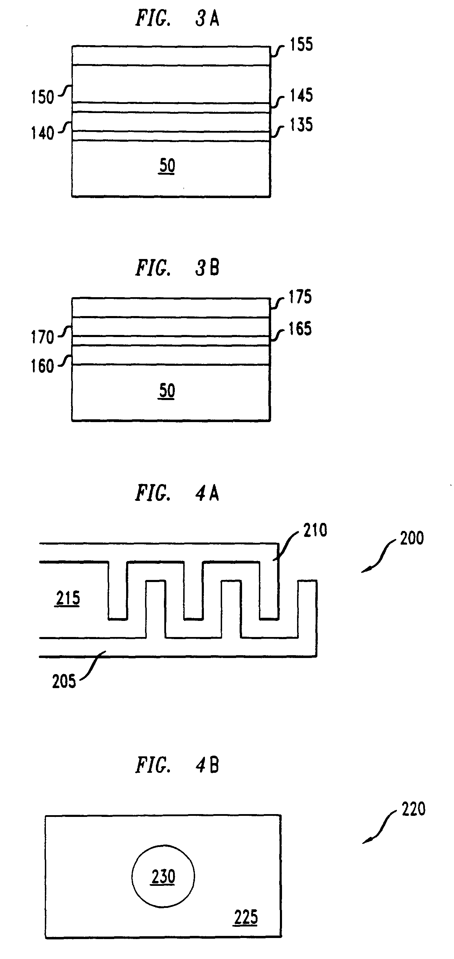

Referring to **FIGS. 3(a)** and **3(b),** a first and second alternative arrangement to resonator **40** shown in **FIGS. 1** and **2** are illustrated. With respect to **FIG. 3(a),** an adhesive layer **135** is formed above resonator substrate base **50.** Adhesive layer **135** functionally provides adhesive properties for a subsequent layer formed thereon. Adhesive layer **135** is continuous, though the formation of pinholes should not preclude its use. Adhesive layer **135** comprises titanium (Ti) or chromium (Cr), though substitutes, such as, for example, zirconium (Zr), halfnium (Hf), vanadium (V), niobium (Nb), tantalum (Ta), molybdenum (Mo), and tungsten (W), will become apparent to one of ordinary skill upon reviewing the disclosure herein. Formed above adhesive layer **135** is a bottom electrode **140** comprising aluminum (A1). Moreover, a textured film **145** of platinum (Pt) for promoting nucleation and crystallinity in a subsequently formed layer is also incorporated above electrode **140.** Formed upon textured film **145** is a piezoelectric crystalline layer **150** and a top electrode **155.**

With respect to **FIG. 3(b),** an adhesive electrode layer **160** is formed above resonator substrate base **50.** Adhesive electrode layer **160** comprises titanium (Ti) or chromium (Cr), though substitutes, such as, for example, zirconium (Zr), halfnium (Hf), vanadium (V), niobium (Nb), tantalum (Ta), molybdenum (Mo), and tungsten (W), will become apparent to one of ordinary skill upon reviewing the disclosure herein. Formed above adhesive electrode layer **160** is a textured film **165** for promoting nucleation in a subsequently formed layer. Formed upon textured film **165** is a textured piezoelectric layer **170** and a top electrode **175.**

Referring to **FIGS. 4(a)** and **4(b),** top views of a Surface Acoustic Wave ("SAW") device **200** and a Bulk Acoustic Wave ("BAW") device **220** are illustrated. SAW device **200** comprises a pair of electrode elements **205** and **210** formed over a resonating element **215.** Each electrode element, **205** and **210,** acting as an InterDigital Transducer ("IDT"), enables an acoustic wave to propagate transversely. In contrast, BAW device **220** comprises a bottom and a top electrode, **225** and **230,** and a resonating element (not shown) formed therebetween, for enabling the propagation of a compressive, longitudinal acoustic wave.

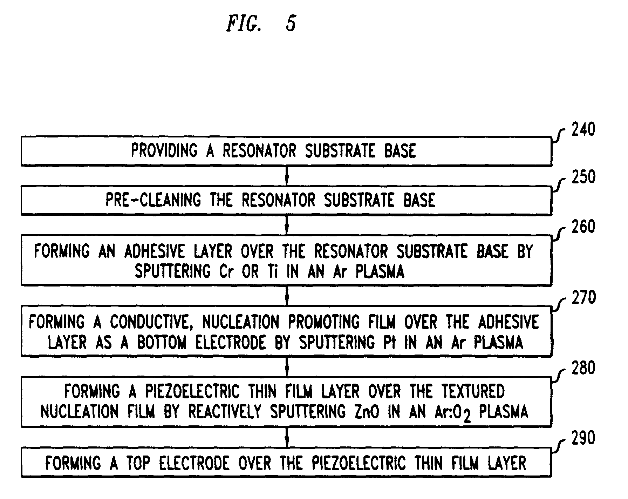

Referring to **FIG. 5,** a flow chart of a method of fabricating a resonator is illustrated. As noted hereinabove, the fabricated resonator may be an acoustics wave component, such as a BAW or a SAW device. Moreover, while the resonator ' detailed comprises a textured piezoelectric layer of zinc oxide, various alternatives will become apparent to one of ordinary skill in the art upon reviewing the disclosure herein.

Initially, the method comprises the step of providing **(240)** a resonator substrate base. The resonator substrate base, as detailed hereinabove, comprises a number of layers in a stacked configuration. It should be apparent to one of ordinary skill in the art, however, that the resonator substrate base may also comprise an air gap acoustic cavity.

The resonator substrate base comprises a substrate layer. In one embodiment of the present invention, the substrate layer comprises silicon (Si). Various substitutes, however, should be apparent to one of ordinary skill in the art that resonator including diamond, quartz, silicon carbide (SiC), sapphire (Al₂O₃), gallium arsenide (GaAs), as well as other materials apparent to one of ordinary skill in the art upon reviewing the present disclosure.

The resonator substrate base also comprises a stack of dielectric layers. The dielectric stack comprises at least one set of alternating amorphous silicon dioxide (a-SiO₂) and amorphous aluminum nitride (a-AIN) layers. In one example, the dielectric stack comprises a nine (9) layers. Here, the dielectric nine (9) layer stack comprises four amorphous silicon dioxide (a-SiO₂) layers, and four amorphous aluminum nitride (a-AIN) layers, formed respectively thereon, with an uppermost amorphous silicon dioxide (a-SiO₂) layer disposed above the top amorphous aluminum nitride (a-AlN) layer. It should be apparent to one of ordinary skill in the art that alternative arrangements and materials may be employed for the stacked dielectric layers. Therefore, for example, silicon dioxide (SiO₂), for example, may be used in place of amorphous silicon dioxide (a-SiO₂), and likewise, aluminum nitride (AlN) may be substituted for amorphous aluminum nitride (a-AIN).

Upon providing the resonator substrate base, a pre-clean **(250)** step is performed. This step is intended to clean the uppermost base surface prior to forming a layer thereon. The pre-clean step may be executed using various known methods, though it is advantageous to clean the substrate in the presence of an argon (Ar) and nitrogen (N₂) plasma etch. It is also advantageous to evaluate the cleanliness of the chamber prior to executing the pre-clean step by achieving a base pressure measure by a vacuum gauge.

Subsequently, an adhesive layer is formed over the now cleaned uppermost silicon dioxide layer. The adhesive layer functionally provides adhesive properties for a subsequent layer formed thereon. The adhesive layer is continuous, though the formation of pinholes should not preclude its use. The adhesive layer comprises titanium (Ti) or chromium (Cr), though substitutes, such as, for example, zirconium (Zr), halfnium (Hf), vanadium (V), niobium (Nb), tantalum (Ta), molybdenum (Mo), and tungsten (W), as well as certain alloys will become apparent to one of ordinary skill upon reviewing the disclosure herein. In one embodiment of the present invention, the adhesive layer is formed by a sputtering step in the presence of an argon (Ar) plasma. This sputtering step is realized, advantageously, using various other conditions and parameters, including heating the substrate at pressure with a DC power supply. It is also advantageous to clean the sputtering target prior to forming the adhesive layer.

Once the desired thickness for the adhesive layer is realized, a nucleation promoting film for promoting subsequent nucleation and crystallinity is formed over the adhesive layer. The textured film functionally acts as an electrode, and advantageously comprises non-oxidizing, conductive properties. In one embodiment, the nucleation promoting film acting as the electrode comprises platinum (Pt), though various non-oxidizing alternatives, such as Au for example, may also be employed. In another embodiment the nucleation promoting film has an orientation of <111> face centered cubic ("fcc") structure such that the atomic planes of the crystalline structure formed are parallel with the resonator substrate base to further promote nucleation of the subsequently formed textured piezoelectric layer. It should be noted that in a further embodiment of the present invention, the nucleation promoting film is patterned. The nucleation promoting film is advantageously formed by a sputtering step in the presence of an argon (Ar) plasma. This sputtering step is realized using various other conditions and parameters, including heating the substrate at pressure and utilizing a DC power supply. It is also advantageous to clean the sputtering target prior to forming the nucleation promoting film.

Thereafter, a textured piezoelectric layer having an oriented and atomically ordered, crystalline structure is formed over the nucleation promoting film. In one embodiment of the present invention, the textured piezoelectric layer comprises a zinc oxide thin film is formed by a reactive sputtering step in the presence of a reactive plasma, such as Ar:O₂ for example. This reactive sputtering step is realized using various other conditions and parameters, including advantageously heating the substrate at pressure while utilizing an RF power supply, though a pulsed DC power supply is a viable alternative. It is also advantageous to clean the sputtering target prior to forming the textured piezoelectric layer. In another embodiment, the resonator substrate base, including the adhesive layer and textured film forming the first electrode, are rotated while the reactive sputtering step is executed. It also should be noted that while the present invention employs a thin film of zinc oxide for the textured piezoelectric layer, substitutes, such as aluminum nitride (AlN) or cadmium sulfide (CdS), as well as other materials having the Wurtzite structure, will become apparent to one of ordinary skill in the art upon reviewing the disclosure herein.

Once the textured piezoelectric layer is formed, the second or top electrode is deposited. The top electrode may be patterned to form an electrical contact. The top electrode comprises aluminum (A1). Various alternatives, however, such as Ti or Au, for example, will become apparent to one of ordinary skill upon reviewing the disclosure herein. Fundamentally, these substitutes may be characterized as being conductive, adhesive, and/or non-oxidizing. Moreover, the mass loading, density and acoustic loss of a selected alternative should also not adversely effect the ability of the textured piezoelectric layer to resonate.

### EXAMPLE

In one experiment, a resonator was formed having a fundamental frequency of approximately 3.5 GHz. To that end, the resonator substrate base employed had a silicon (Si) substrate base, with each of the subsequent five amorphous silicon dioxide layers and four amorphous aluminum nitride layers having approximate thicknesses of 4300Å and 7600Å, respectively. The adhesive layer of titanium (Ti) formed above the uppermost amorphous silicon dioxide layers had a thickness of approximately 100Å, while both the nucleation promoting film of Pt and the top electrode each had a thickness of approximately 1000Å. The zinc oxide layer, sandwiched between the nucleation promoting film of Pt and the top electrode, had a thickness of approximately 0.72 µm.

In this experiment, the pre-clean step included first cleaning the chamber at a base pressure of approximately 9x10⁻⁸ Torr, and then heating the substrate to approximately 200°C in an atmosphere of argon (Ar) and nitrogen (N₂) in a plasma discharge having ratio of 3:2, with a pressure of approximately 10 mTorr. Thereafter, a sputtering step was performed to fabricate the titanium (Ti) adhesive layer. The sputtering target was first pre-sputtered for approximately 30 seconds, and then the titanium (Ti) sputtered over the uppermost amorphous silicon dioxide layer to form a titanium (Ti) layer. This sputtering step was executed while heating the substrate to approximately 200°C at a pressure of approximately 6 mTorr, with the sputtering tool powered by a 3kW DC power supply. Subsequently, the textured platinum (Pt) thin film was formed, after sputtering target was pre-sputtered for approximately 30 seconds. The sputtering of the platinum (Pt) thin film was executed while heating the substrate to approximately 200°C at a pressure of approximately 10 mTorr, with the sputtering tool powered by a 3kW DC power supply.

With respect to the zinc oxide thin film, a radio frequency ("RF") planar magnetron sputtering tool, the ANELVA SPF-332H was used to form the zinc oxide film. The tool consisted of a cryogenic vacuum pump for realizing a base pressure less than 5 x 10⁻⁷ Torr, and an RF power supply at a frequency of 13.56 MHz with a matching unit. The RF power supply also had a 2.0 kV plate voltage and 91 mA plate current, incident power of 120W, and reflected power of 75 W. The tool further employed a 3 inch diameter coaxial planar magnetron under the target holder, and Ar and O₂ gas inlet, as well as quartz lamps for heating the substrate. The zinc target was 3 inches diameter, 0.125 inches thick, spaced 9.5 cm from the substrate, and was 3 mm from a 2.5 inch target aperture.

The zinc target was obtained from Pure Tech having a purity of 99.995%. The Zn target was reactively sputtered in an Ar:O₂ plasma at a 1:1 ratio, discharging at 5 sccm flow rates for each gas with varying chamber pressures. A 4 inch main butterfly valve was incorporated to control the total pressure in the system during the deposition step. High purity gases, such as Ar and O₂, were premixed and introduced into the system. The flow rates were adjusted by manual leak valves, and measured using flowmeters obtained from Matheson. The total working pressure in the system was measured with a MKS Baratron capacitance gauge.

Prior to depositing the zinc oxide onto the substrate, the target was presputtered for 10 minutes. During this period, a shutter was present to prevent zinc oxide deposition onto the substrate. After presputtering, the shutter was removed, and the plasma impedance changed accordingly. As a result, the RF power source was retuned using the accompanying matching unit to optimize the sputtering process step. For the realized thickness of approximately 0.72 µm, the zinc oxide thin film had a total sputtering time of approximately 2 hours and a sputtering rate of 64 Å/minute.

During sputtering, the substrates were placed parallel to the target surface in a sputter-down geometry. The substrates were either intentionally heated with the incorporated quartz lamps to temperatures varying from 200°C to 700°C, or to a temperature between 45°C and 65°C due to the energetic particle bombardment. The substrate temperature was measured by a thermocouple situated below and in contact with the substrate.

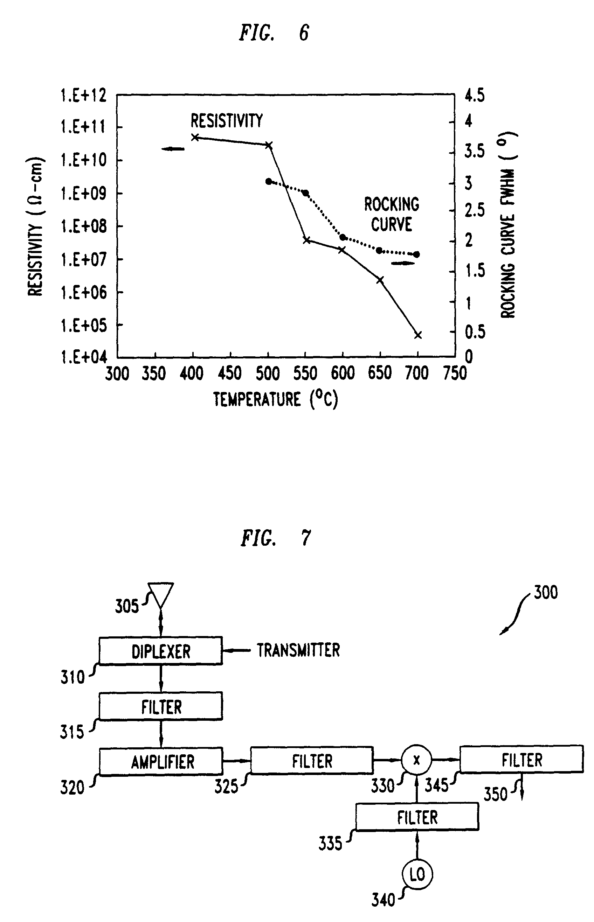

Referring to **FIG. 6,** a graph depicting the contrast between the resistivity and the full width at half maximum of the diffraction angle, ω, commonly referred to as "rocking curve," of a zinc oxide thin film formed over a textured film of Pt, as a function of substrate temperature is illustrated. This graph depicts the results of the example detailed hereinabove. Ideally, the resonator should have a maximized resistivity and a minimized rocking curve. From the graph, formulated utilizing x-ray diffraction, a heating step of approximately 600°C to 650°C during the formation of the zinc oxide thin film appears advantageous.

Referring to **FIG. 7,** a block diagram of a radio frequency ("RF") device **300** is illustrated according to another embodiment of the present invention. RF device **300** depicts an application of the present invention. As will be apparent to one of ordinary skill upon reviewing the disclosure herein, RF device **300** may be realized by a personal communication services ("PCS") device, a cellular phone, a pager, a communications satellite, as well as other transmitter and/or receiver applications and other electronic devices requiring a resonator.

RF device **300** comprises an antenna **305** for receiving or transmitting a signal from a diplexer **310.** In an alternative embodiment, diplexer **310** is coupled with a transmitter (not shown). Diplexer **310** passes the signal to a filter **315** for filtering and generating a resultant band limited signal. The band limited signal is then amplified by amplifier **320,** and filtered by filter **325** to generate a further band limited signal. The twice band limited signal is thereafter passed into a mixer **330.** Mixer **330** mixes the twice band limited signal with a local oscillator signal generated by a local oscillator **340** and filtered by a band limited filter **335.** The resultant mixed output signal is then passed through a band limited filter **345** to remove the local oscillator signal. As a result, an intermediate frequency ("IF") output **350** is generated as an output of filter **345** which is passed along to an IF receiver component (not shown) for subsequent processing.

In the present embodiment, local oscillator **340** comprises a resonator formed from a thin film. As detailed hereinabove, the thin film based resonator has a stacked configuration comprising a resonator substrate base, a bottom electrode, and adhesive layer, a nucleation film, a reactively sputtered thin film based textured piezoelectric layer, and a top electrode. The reactively sputtered textured piezoelectric layer in one embodiment comprises zinc oxide, though alternatives will become apparent to one of ordinary skill upon reviewing the disclosure herein. It should also be apparent to one of ordinary skill that filters **315, 325, 335** and **345** may also be realized by resonator filters.

While the particular invention has been described with reference to illustrative embodiments, this description is not meant to be construed in a limiting sense. It is understood that although the present invention has been described, various modifications of the illustrative embodiments, as well as additional embodiments of the invention, will be apparent to one of ordinary skill in the art upon reference to this description without departing from the spirit of the invention, as recited in the claims appended hereto. Thus, while a resonator and a method of fabricating a resonator are disclosed, it should be apparent to one of ordinary skill that the present invention may also be applied as a filter, such as a band limited filter, as well as other devices relying on the transducer phenomenon of the resonator which converts electrical energy to mechanical vibrations as well as converting mechanical vibrations to electrical energy. Moreover, the structure and method for fabricating the textured zinc oxide film utilizing the nucleation promoting film may have additional applications beyond resonators or the like that will become apparent to one of ordinary skill upon reviewing the instant disclosure. It is therefore contemplated that the appended claims will cover any such modifications or embodiments as fall within the true scope of the invention.

## Claims

1. A method of fabricating a resonator comprising the steps of:
providing a substrate base;
forming an adhesive layer over the substrate base;
forming a nucleation promoting film over the adhesive layer, the nucleation promoting film being non-oxidizing;
forming a crystalline layer of zinc oxide over the nucleation promoting film; and
forming a conductive layer over the crystalline layer of zinc oxide.

2. The invention of claim 1, wherein the substrate base comprises an air gap.

3. The invention of claim 1, wherein the nucleation promoting film comprises Pt.

4. The invention of claim 1, wherein the adhesive layer comprises at least one Ti and Cr formed by a sputtering step employing an Ar plasma.

5. The invention of claim 1, wherein the step of forming a nucleation promoting film comprises the step of sputtering Pt with an Ar plasma.

6. The invention of claim 1, wherein step of forming a crystalline layer of zinc oxide comprises the step of a reactive sputtering employing a plasma comprising Ar and O₂.

7. A method of fabricating a resonator comprising the steps of:
providing a resonator substrate base;
forming an adhesive layer over the resonator substrate base;
forming a nucleation promoting film of Pt over the adhesive layer;
reactively sputtering a piezoelectric layer of zinc oxide over the nucleation promoting film of Pt; and
forming a top electrode over the zinc oxide layer.

8. The invention of claim 7, wherein the substrate base comprises an air gap.

9. The invention of claim 7, wherein the adhesive layer comprises at least one Ti and Cr formed by a sputtering step employing an Ar plasma.

10. The invention of claim 7, wherein the step of forming a nucleation promoting film of Pt comprises a sputtering step employing an Ar plasma.

11. The invention of claim 7, wherein the step of reactively sputtering a layer of zinc oxide employs a plasma comprises Ar and O₂.

12. The invention of claim 7, wherein the step of reactively sputtering a layer of zinc oxide is realized while rotating the substrate base.

13. A resonator comprising:
a resonator substrate base;
an adhesive layer formed over the resonator substrate base;
a nucleation promoting film formed over the adhesive layer, the nucleation promoting film comprising Pt;
a crystalline layer of zinc oxide formed over the nucleation promoting film; and
a top electrode formed over the crystalline layer of zinc oxide.

14. The invention of claim 13, wherein the resonator substrate base comprises an air gap.

15. The invention of claim 13, wherein the adhesive layer comprises at least one Ti and Cr.

16. The invention of claim 13, wherein the nucleation promoting film comprises Pt.

17. A textured crystalline structure comprising:
a textured zinc oxide layer; and
a nucleation promoting film for promoting the formation of the textured zinc oxide layer, the nucleation promoting film comprising Pt.

18. The textured crystalline structure of claim 17, wherein the nucleation promoting film comprises a <111> orientation.

19. An electronic device comprising:
an antenna for at least one of receiving and transmitting at least one signal;
a filter for filtering the at least one signal;
an amplifier for amplifying the at least one signal; and
a mixer having an oscillator for mixing the at least one signal, the oscillator having a resonator comprising:
a resonator substrate base;
an adhesive layer formed over the resonator substrate base;
a nucleation promoting film formed over the adhesive layer, the nucleation promoting film comprises Pt;
a crystalline layer of zinc oxide formed over the nucleation promoting film; and
a top electrode formed over the crystalline layer of zinc oxide.

20. The electronic device of claim 19, wherein the nucleation promoting film comprises a <111> orientation.
